# EUROPÄISCHE PATENTSCHRIFT

(11) **EP 2 171 253 B1**
(45) Veröffentlichungstag und Bekanntmachung des Hinweises auf die Patenterteilung: **14.09.2011**
(21) Anmeldenummer: 08775064.2
(22) Anmeldetag: 15.07.2008
(51) Int. Cl.: F02M 51/06, F02M 61/16, H01L 41/053

(54) **AKTOREINHEIT FÜR EIN EINSPRITZSYSTEM EINER BRENNKRAFTMASCHINE**
ACTUATOR UNIT FOR AN INJECTION SYSTEM OF AN INTERNAL COMBUSTION ENGINE
UNITÉ D'ACTIONNEMENT POUR UN SYSTÈME D'INJECTION D'UN MOTEUR À COMBUSTION INTERNE

(30) Priorität: 16.07.2007 DE 102007033033
(43) Veröffentlichungstag der Anmeldung: 07.04.2010
(73) Patentinhaber: Continental Automotive GmbH, 30165 Hannover (DE)
(72) Erfinder: DICK, Jürgen, 93164 Laaber (DE); FREUDENBERG, Hellmut, 93080 Grossberg (DE); PIRKL, Richard, 93055 Regensburg (DE)
(86) Internationale Anmeldenummer: PCT/EP2008/059204
(87) Internationale Veröffentlichungsnummer: WO 2009/010501

(56) Entgegenhaltungen:
- DE-A1- 2 917 933
- DE-A1- 10 303 855
- DE-A1- 19 909 106
- JP-A- 11 280 932
- US-A- 4 471 256
- US-A- 4 553 059

## Beschreibung

Die Erfindung betrifft eine Aktoreinheit für ein Einspritzsystem einer Brennkraftmaschine gemäß den Merkmalen des Oberbegriffs des Patentanspruchs 1 (JP-A-11/280932).

Aktoreinheiten mit piezoelektrischen Aktorelementen werden beispielsweise zur Kraftstoffeinspritzung in Brennräumen von Brennkraftmaschinen eingesetzt. Die piezoelektrischen Aktorelemente bestehen vorzugsweise aus Keramik und sind in einem Aktorgehäuse angeordnet, das beispielsweise aus Invar besteht. Da die unterschiedlichen Materialien des Aktorgehäuses und des piezoelektrischen Aktorelements unterschiedliche Werte für den jeweiligen Wärmeausdehnungskoeffizienten aufweisen, kann es bei einer Änderung der auf die Aktoreinheit wirkenden Temperatur zu unterschiedlichen Längenänderungen des piezoelektrischen Aktorelements und des Aktorgehäuses kommen. Dadurch kann sich die Position des piezoelektrischen Aktorelements in Bezug auf ein Stellglied verschieben, so dass die Wirkverbindung zwischen dem piezoelektrischen Aktorelement und dem Stellglied entsprechend beeinflusst wird.

In der Patentschrift DE 199 09 106 C2 wird eine Aktoreinheit offenbart, bei der Längenänderungen, die sich aufgrund unterschiedlicher Wärmeausdehnungskoeffizienten für die verschiedenen Materialien von Aktorgehäuse und piezoelektrischen Aktorelement ergeben, dadurch ausgeglichen werden, dass sich das Aktorgehäuse aus einer inneren, mittleren und äußeren Hülse zusammensetzt. Dabei weisen mindestens zwei Hülsen einen unterschiedlichen Wärmeausdehnungskoeffizienten auf. Die Materialien der Hülsen werden derart ausgewählt, dass infolge der unterschiedlichen Wärmeausdehnungskoeffizienten der einzelnen Hülsen die unterschiedlichen Längenänderungen am Aktorgehäuse und am piezoelektrischen Aktorelement ausgeglichen werden.

Die der vorliegenden Erfindung zu Grunde liegende Aufgabe besteht nun darin, eine Alternativlösung für eine Aktoreinheit bereitzustellen, mittels der die unterschiedlichen Längenausdehnungen des Aktorgehäuses und des piezoelektrischen Aktorelements möglichst einfach ausgeglichen werden können.

Diese Aufgabe wird erfindungsgemäß durch die Merkmale des Patentanspruchs 1 gelöst. Vorteilhafte Ausgestaltungen der Erfindung sind in den Unteransprüchen gekennzeichnet.

Die mit der Erfindung erzielten Vorteile bestehen insbesondere darin, dass, ausgehend von einem bekannten Wärmeausdehnungskoeffizienten des piezoelektrischen Aktorelements, die unterschiedliche Längenausdehnung des Aktorgehäuses und des piezoelektrischen Aktorelements in axialer Richtung dadurch ausgeglichen wird, dass an dem Aktorgehäuse ein einen Kraftausgleich bewirkendes Befestigungselement angeordnet ist. Unterstützt wird dies durch die Wahl der Wärmeausdehnungskoeffizienten des Aktorgehäuses und des Befestigungselements derart, dass eines der Materialien einen im Vergleich zum Wärmeausdehnungskoeffizienten des piezoelektrischen Aktorelements größeren Wärmeausdehnungskoeffizienten und das jeweils andere Material einen im Vergleich zum Wärmeausdehnungskoeffizienten des piezoelektrischen Aktorelements kleineren Wärmeausdehnungskoeffizienten aufweist.

In vorteilhafter Weiterbildung der Erfindung ist vorgesehen, dass das Befestigungsmittel als Spannmutter ausgebildet und an einem an dem Aktorgehäuse angebrachten Gewinde befestigt ist. Die Anordnung der Spannmutter am Aktorgehäuse bietet insofern den Vorteil, dass die unterschiedlichen Längenänderungen des Aktorgehäuses und des piezoelektrischen Aktorelements ohne eine Formänderung der Aktoreinheit erfolgt. Somit ist eine kostengünstige und schnelle Nachbearbeitung der Aktoreinheit möglich.

Eine weitere vorteilhafte Ausgestaltung der Erfindung besteht darin, dass über die Länge des in das Gewinde eingreifenden Teils der Spannmutter eine Feinjustierung des Ausgleichs der unterschiedlichen Längenausdehnungen des Aktorgehäuses und des piezoelektrischen Aktorelements erfolgt. Die Länge des in das Gewinde des Aktorgehäuses eingreifenden Teils der Spannmutter hängt vom Wärmeausdehnungskoeffizienten des piezoelektrischen Elements ab. Der Vorteil besteht daher darin, dass durch eine alleinige Längenänderung des in das Gewinde des Aktorgehäuses eingreifenden Teils der Spannmutter unterschiedliche Längenänderungen des gleichen Materials, die z.B. bei einer Lieferung des gleichen Materials durch unterschiedliche Hersteller auftreten können, vermieden werden.

Einzelheiten der Erfindung werden anhand der Zeichnung näher erläutert. Dabei zeigt:

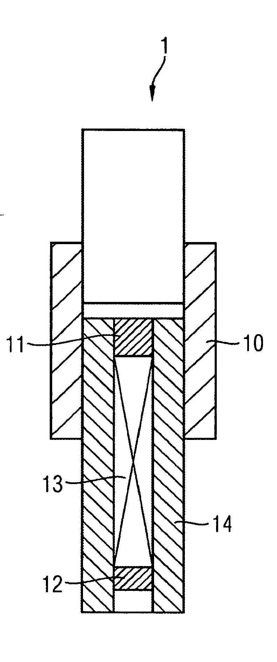

Figur 1: eine Schnittansicht einer Aktoreinheit.

Figur 1 zeigt eine Schnittansicht einer Aktoreinheit. Die Aktoreinheit 1 weist ein piezoelektrisches Aktorelement 13 auf, welches innerhalb eines Aktorgehäuses 14 angeordnet ist. Das piezoelektrische Aktorelement 13 ist an einem Ende mit einem Kopfelement 11 und am gegenüberliegenden Ende mit einem Bodenelement 12 verbunden. Ferner ist an dem Aktorgehäuse 14 ein Befestigungselement 10 angeordnet. Bei dem Befestigungselement 10 handelt es sich beispielsweise um eine Spannmutter. In einer vorteilhaften Ausführungsform der Aktoreinheit besteht das piezoelektrische Aktorelement 13 aus Keramik, das Aktorgehäuse 14 aus Nickelstahl, und das Befestigungselement 10 aus Stahl.

Aufgrund der unterschiedlichen Wärmeausdehnungskoeffizienten für die Materialien des piezoelektrischen Aktorelements 13 und des Aktorgehäuses 14 erfolgt bei einer Temperaturänderung eine unterschiedliche Längenänderung des Aktorgehäuses 14 und des piezoelektrischen Aktorelements 13 der Aktoreinheit in axialer Richtung. Die Position des piezoelektrischen Aktorelements 13 kann sich dabei in Bezug auf ein in der Figur 1 nicht dargestelltes Stellglied verändern. Dadurch kann eine Wirkverbindung zwischen dem piezoelektrischen Aktorelement 13 und dem in der Figur 1 nicht dargestellten Stellglied so beeinflusst werden, dass z.B. die Steuerung der einzuspritzenden Kraftstoffmenge bei Einspritzventilen verschlechtert wird.

Die sich bei einer Temperaturänderung in der Aktoreinheit 1 zwischen dem piezoelektrischen Aktorelement 13 und Aktorgehäuse 14 ergebende unterschiedliche Längenänderung wird durch das Befestigungselement 10 ausgeglichen. Ein Ausgleich der unterschiedlichen Längenausdehnung durch das Befestigungselement 10 erfolgt insofern, als durch das Befestigungselement 10 eine Kraftkomponente in axialer Richtung auf das Aktorgehäuse 14 entgegen der Bewegung des Aktorgehäuses 14 ausgeübt wird. Da das Befestigungselement 10 beispielsweise als Spannmutter ausgebildet ist, ist die auf das Aktorgehäuse 14 ausgeübte Kraft umso größer, je länger der in das Gewinde des Aktorgehäuses 14 eingreifende Teil der Spannmutter ist.

Das Befestigungselement 10, das Aktorgehäuse 14 und das piezoelektrische Aktorelement 13 werden vorzugsweise aus jeweils unterschiedlichen Materialien gefertigt, die einen unterschiedlichen Wärmeausdehnungskoeffizienten aufweisen. Damit die unterschiedlichen Längenänderungen zwischen dem Aktorgehäuse 1 und dem Befestigungselement 10, in Bezug auf die Längenänderung des piezoelektrischen Aktorelements 13, ausgeglichen werden, sind die Materialien des Befestigungselements 10 und des Aktorgehäuses 1 derart gewählt, dass eines der beiden Materialien einen im Vergleich zum Wärmeausdehnungskoeffizient des piezoelektrischen Aktorelements 13 größeren Wärmeausdehnungskoeffizienten, und das jeweils andere Material einen im Vergleich zum Wärmeausdehnungskoeffizienten des piezoelektrischen Aktorelements 13 kleineren Wärmeausdehnungskoeffizienten aufweist.

Im Folgenden wird der Fall betrachtet, dass der Wärmeausdehnungskoeffizient des Befestigungselements 10 kleiner ist als der Wärmeausdehnungskoeffizient des piezoelektrischen Aktorelements 13, und gleichzeitig der Wärmeausdehnungskoeffizient des Aktorgehäuses 14 größer ist als der Wärmeausdehnungskoeffizient des piezoelektrischen Aktorelements 13. Somit erfolgt aufgrund des größeren Wärmeausdehnungskoeffizienten des Aktorgehäuses 14 eine im Vergleich zum piezoelektrischen Aktorelement 13 zu große Längenausdehnung des Aktorgehäuses 14. Diese im Vergleich zum piezoelektrischen Aktorelement 13 zu große Längenausdehnung wird durch das Befestigungselement 10 insofern ausgeglichen, da nun aufgrund des geringeren Wärmeausdehnungskoeffizienten des Befestigungselements 10 eine entgegen der axialen Bewegungsrichtung des Aktorgehäuses 14 gerichtet Kraft auf das Aktorgehäuse 14 wirkt.

## Patentansprüche

1. ktoreinheit mit einem ein piezoelektrisches Aktorelement (13) umschließendes Aktorgehäuse (14), bei der das Aktorgehäuse und das piezoelektrische Aktorelement aus unterschiedlichen Materialien mit entsprechend unterschiedlichen Wärmeausdehnungskoeffizienten, gefertigt sind, wobei
an dem Aktorgehäuse ein Befestigungselement (10) angeordnet ist, dessen Material sich jeweils vom Material des Aktorgehäuses und vom Material des piezoelektrischen Aktorelements bezüglich des Wärmeausdehnungskoeffizienten unterscheidet und dass die Materialien von Aktorgehäuse und Befestigungselement so gewählt sind, dass eines der Materialien einen im Vergleich zum Wärmeausdehnungskoeffizienten des piezoelektrischen Aktorelements größeren Wärmeausdehnungskoeffizienten und das jeweils andere Material einen im Vergleich zum Wärmeausdehnungskoeffizienten des piezoelektrischen Aktorelements kleineren Wärmeausdehnungskoeffizienten aufweist, **dadurch gekennzeichnet, dass** das Befestigungselement in ein am Aktorgehäuse angebrachtes Gewinde eingreift.

2. Aktoreinheit nach Anspruch 1, **dadurch gekennzeichnet, dass** das Befestigungselement auf dem Aktorgehäuse axial verspannt ist.

3. Aktoreinheit nach Anspruch 1 oder 2, **dadurch gekennzeichnet, dass** das Befestigungselement als Spannmutter ausgebildet ist.

4. Aktoreinheit nach Anspruch 3, **dadurch gekennzeichnet, dass** die Länge des in das Gewinde eingreifenden Teils der Spannmutter vom Wärmeausdehnungskoeffizient des piezoelektrischen Aktorelements abhängt.

5. Aktoreinheit nach einem der vorhergehenden Ansprüche, **dadurch gekennzeichnet, dass** das Befestigungselement aus Stahl, das Aktorgehäuse aus Invar und das piezoelektrische Aktorelement aus Keramik besteht.

## Claims

1. Actuator unit which comprises an actuator housing (14) enclosing a piezoelectric actuator element (13) and in which the actuator housing and the piezoelectric actuator element are produced from different materials with correspondingly different coefficients of thermal expansion, a fastening element (10) being arranged on the actuator housing, the material of said fastening element differing from the material of the actuator housing and from the material of the piezoelectric actuator element with respect to the coefficient of thermal expansion and the materials of the actuator housing and of the fastening element being chosen such that one of the materials has a greater coefficient of thermal expansion in comparison with the coefficient of thermal expansion of the piezoelectric actuator element and the other material, respectively, has a smaller coefficient of thermal expansion in comparison with the coefficient of thermal expansion of the piezoelectric actuator element, **characterized in that** the fastening element engages in a thread provided on the actuator housing.

2. Actuator unit according to Claim 1, **characterized in that** the fastening element is axially braced on the actuator housing.

3. Actuator unit according to Claim 1 or 2, **characterized in that** the fastening element is formed as a clamping nut.

4. Actuator unit according to Claim 3, **characterized in that** the length of the part of the clamping nut that engages in the thread depends on the coefficient of thermal expansion of the piezoelectric actuator element.

5. Actuator unit according to one of the preceding claims, **characterized in that** the fastening element consists of steel, the actuator housing consists of Invar and the piezoelectric actuator element consists of ceramic.

## Revendications

1. Unité d'actionneur avec un boîtier d'actionneur (14) entourant un élément d'actionneur piézoélectrique (13), dans laquelle le boîtier d'actionneur et l'élément d'actionneur piézoélectrique sont fabriqués à partir de matériaux différents avec des coefficients de dilatation thermique correspondants différents, dans laquelle
un élément de fixation (10) est disposé sur le boîtier d'actionneur, dont le matériau diffère respectivement du matériau du boîtier d'actionneur et du matériau de l'élément d'actionneur piézoélectrique quant au coefficient de dilatation thermique, et les matériaux du boîtier d'actionneur et de l'élément de fixation sont choisis de sorte que l'un des matériaux présente un coefficient de dilatation thermique supérieur au coefficient de dilatation thermique de l'élément d'actionneur piézoélectrique et que l'autre matériau respectif présente un coefficient de dilatation thermique inférieur au coefficient de dilatation thermique de l'élément d'actionneur piézoélectrique, **caractérisée en ce que** l'élément de fixation s'engrène dans un filetage monté sur le boîtier d'actionneur.

2. Unité d'actionneur selon la revendication 1, **caractérisée en ce que** l'élément de fixation est serré axialement sur le boîtier d'actionneur.

3. Unité d'actionneur selon la revendication 1 ou 2, **caractérisée en ce que** l'élément de fixation se présente sous la forme d'un écrou tendeur.

4. Unité d'actionneur selon la revendication 3, **caractérisée en ce que** la longueur de la partie de l'écrou tendeur s'engrenant dans le filetage dépend du coefficient de dilatation thermique de l'élément d'actionneur piézoélectrique.

5. Unité d'actionneur selon l'une quelconque des revendications précédentes, **caractérisée en ce que** l'élément de fixation est constitué d'acier, le boîtier d'actionneur d'Invar et l'élément d'actionneur piézoélectrique de céramique.
